# EUROPEAN PATENT SPECIFICATION

(11) **EP 4 094 878 B1**
(45) Date of publication and mention of the grant of the patent: **31.12.2025**
(21) Application number: 21176188.7
(22) Date of filing: 27.05.2021
(51) Int. Cl.: B23K 26/24, H05K 7/14, B23K 101/36, B23K 103/12

(54) **METHOD FOR FORMING A BUSBAR HAVING A CONTACT SECTION, BUSBAR HAVING A CONTACT SECTION AND POWER DISTRIBUTION SYSTEM HAVING SUCH A BUSBAR**
VERFAHREN ZUR HERSTELLUNG EINER SAMMELSCHIENE MIT EINEM KONTAKTABSCHNITT, SAMMELSCHIENE MIT EINEM KONTAKTABSCHNITT UND LEISTUNGSVERTEILUNGSSYSTEM MIT EINER SOLCHEN SAMMELSCHIENE
PROCÉDÉ DE FORMATION D'UNE BARRE BUS AYANT UNE SECTION DE CONTACT, BARRE BUS AYANT UNE SECTION DE CONTACT ET SYSTÈME DE DISTRIBUTION DE PUISSANCE AYANT UNE TELLE BARRE BUS

(43) Date of publication of application: 30.11.2022
(73) Proprietor: Rogers BV, 9940 Evergem (BE)
(72) Inventor: Tang, Liang, 9940 Evergem (BE); Hu, Xiaobo, 9940 Evergem (BE); Yang, Jianning, 9940 Evergem (BE)
(74) Representative: Müller Schupfner & Partner Patent- und Rechtsanwaltspartnerschaft mbB (Muc)

(56) References cited:
- EP-A1- 3 654 742
- EP-A1- 3 739 695
- US-A1- 2008 100 993

## Description

The present invention concerns a method for forming a busbar having a contact section, a busbar having a contact section and a power distribution system having such a busbar.

Laminated busbars typically comprise conductive sections of fabricated copper separated by thin dielectric materials, laminated into a unified structure. Examples for laminated busbars can be found in CN 203 504 394 U, CN 104 022 414 A1 or CN 202 474 475 U. Usually a contact section is included in the busbar, in order to connect electrical poles of an electronic component, such as a capacitor, an IGBT and even another connection busbar, directly to different conductive sections, wherein each of the conductive sections is assigned to a type of poles provided by each component. Typically, the components are connected to the connected region by nuts and bolts/pins

For avoiding corrosion or oxidation of these busbars, the busbar is typically covered by a nickel and/or tin cladding, in particular a nickel and/or tin plating. However, covering the whole busbar with a nickel and/o tin plating is comparable cost intensive.

Further, it is known, for example from US 5,579,217, to use conductive sections made from aluminum. Thus, a comparable light busbar can be provided. Furthermore, EP 3 6547 42 A1 describes a method for manufacturing a busbar being made from aluminum.

However, in some cases busbars made from copper are still needed and preferred for specific applications.

Considering the above, it is an object of the present invention to provide a method for manufacturing a busbar, made mainly from copper, and to provide a busbar that is improved compared to those known in the state of the art, in particular with respect to its manufacturing process.

This object is achieved by a method to form a busbar having a contact section according to claim 1, a busbar having a contact section according to claim 13 and a power distribution system having a busbar according to claim 14. Preferred embodiments are incorporated in the dependent claims, the description and the figures.

According to a first aspect of the present invention a method for forming a busbar having a contact section is provided, comprising:
- providing a first conductive section made from copper,
- providing a second conductive section, preferably made from copper, wherein the second conductive section includes the contact section or is connected to the contact section and wherein the second conductive section is at least partially covered with nickel and/or tin and
- creating a bond, in particular a laser welding seam, i. e. a laser welding bond, between the first conductive section and the second conductive section, by laser welding, in particular for forming the busbar having the contact section.

In contrast to the state of the art, it is provided according to the present invention to connect the contact section to the first conductive section via a second conductive section being covered with nickel and/or tin and to perform the connection between the first conductive section and the second conductive section by a laser welding process. Producing the bond via laser welding accelerates the manufacturing process significantly. Further, it turned out surprisingly that realizing the connection by laser welding establishes a durable and resistant connection between the first conductive element and the second conductive section, in particular if the first conductive section is formed by a bare copper sheet and the second conductive section, being covered with nickel and/or tin, is connected directly to this bare copper sheet, representing the first conductive section. Furthermore, it also turned out that the connection via the laser welding seam establishes a sufficient and reliable electric connection. In addition, it turned out to be of advance to use a separate second conductive section for connecting the contact section to the first conductive section, since covering the second conductive section by nickel and/or tin can be performed in a more simple way compared to covering the whole busbar. Further, material can be saved for creating the busbar.

In general, it is advantageously possible to realize the nickel and/or tin cover only for the second conductive section and to avoid a covering of the first conductive section with nickel and/or tin. In other words: the durable and resistant connection realized by the laser welding allows restricting the cover only to the first conductive section and it is no longer necessary to cover the whole busbar. Thus, material, namely nickel and/or tin, can be saved and consequently the costs can be reduced, without effecting the durability of the manufactured busbar.

In particular, the contact section is defined as a section being intended to make an electrical contact available, in particular an external contact. In other words: the contacts section represents a terminal to provide the current being conducted by the busbar and/or a bushing. For example, the contact section is configured to receive a pin or to connect a cable to the busbar to transfer an electrical current from the busbar. Furthermore, the second conductive section is preferably a part of the busbar, in particular the section without the contact section. Essentially, the first conductive section and the second conductive section form together the busbar and preferably the second conductive section continues the general course of the first conductive section in a main extension plane.

Preferably, the busbar is either a flat product extending in a main extension plane or is bended as a 3D structure, for example U-shaped or L-shaped. The first conductive section and/or the second conductive section are preferably a copper sheet, especially a bare copper sheet that mainly defines the main extension plane. For example, the contact section includes a contact element being a bushing for receiving a pin of the electrical component. Preferably, the bushing has an opening for receiving a pin of the electronical component. Thus, for mounting the electronical component the pin can be inserted into the bushing, in particular in the hole of the bushing.

Preferably, the laser welding seam can be realized in a section, being spaced from the contact section, and therefore simplifies the access of a laser-beam to an interface region between the first conductive section and the second conducive section, the laser welding seam preferably extending at least partially along the interface region between the first and the second conductive section in a finished state of the realized connection. As a consequence, a quality of the realized connection can be further improved. For example the seam is spaced from the contact section about at least 12 mm. It is also conceivable that the second conductive section is formed only by a contact element, such as a bushing, the contact element representing the contact section.

Furthermore, it is provided that that the first conductive section has a first volume and the second conductive section has a second volume, wherein a ratio of the second volume to the first volume is smaller than 0.2, preferably smaller than 0.1 and most preferably smaller than 0.05. In other words: the second conductive section is significantly smaller than the first conductive section.

Preferably, the busbar is a flat product extending in a main extension plane. The term "flat" means that a thickness of the busbar, measured in a direction perpendicular to the main extension plane, is at least 10 times, preferably at least 15 times, smaller than the extensions across the busbar in a plane parallel to the main extension plane. For instance, the busbar is laminated and/or covered with an insulation layer. Such busbars are particularly intended for collecting and transferring electrical power. For example, a plurality of capacitors is arranged on top of the busbar and are connected to the busbar for distributing a total power collected from a plurality of capacitors. Such busbars are intended for being used in electrical vehicles, for example. In particular, the thickness of the busbar, measured in a direction perpendicular to the main extension plane, is between 0.5 mm and 6 mm, more preferably between 3 mm and 6 mm and most preferably between 4.5 mm and 5.5 mm. Although the busbar is comparable thick, it is still configured to be bended to adapt its shape for the corresponding application. In particular, the term "flat" concerns a main body of the busbar, for example at least 70 %, preferably at least 80 % and at least 90 % of the busbar extends in a flat manner. In addition to the pure flat regions or sections, the busbar can include sections extending perpendicular or slanted to a main extension plane of the busbar, thereby being U-shaped for example or L-shaped.

Preferably, the second conductive section has a non-symmetrical cross section in the main extensions plane. The non-symmetrical cross section establishes preferably a positive locking with the first conductive section, the positive locking hindering the second conductive section from being rotated about an axis perpendicular to the main extension plane. Especially, the second conductive section is not completely rotationally symmetric. For example, the second conductive section has a star like, a rectangular or an elliptical shape. Preferably, the cross section is non-circular. In particular, the second conductive section is formed such that connecting the second conductive section with the first connection section makes an orientation of the second conductive section necessary. Especially, the first conductive section and the second conductive section establish a key lock principle. Thus, it is possible to connect the first conductive section and the second conductive section prior to realizing the welding seam.

Preferably, the first conductive section and the second conductive section are connected by a frictional connection and/or a form-fitting connection, in particular prior to establishing the welding seam. As a consequence, it is possible to connect the first conductive section and the second conductive section in a firm manner, for example for handling the assembly of the first conductive section and the second conductive section prior to the welding process. As a result, the assembly can be transferred to the welding machine without risking a separation of the first and the second conductive section. Preferably, the first conductive section and the second conductive section establishes a press fit for establishing the frictional connection.

The form-fitting connection could be created by step like courses in the regions which contacts with each other, when the first conductive section and the second conductive section are assembled.

According to another embodiment of the present invention, the welding seam along the interface section between the first conductive section and the second conductive section is interrupted or extends without an interruption. Preferably, the second conductive section is at least covered in such regions being in contact with the first conductive section in an assembled state.

Further, it is provided that the contact element is connected to the second conductive section such that the contact element protrudes from the second conductive section along a direction being perpendicular to the main extension plane. Especially, the contact element has a front side that faces away from the second conductive section and forms at least a part of a connection surface to which the electronical component, such as a capacitor, an IGBT, or a cable is connected. Preferably, a distance between the second conductive section and said front side facing away from the second conductive section is greater than a thickness of the first conductive section, preferably 1.2 to 5 times, more preferably 1.5 and 4 times and most preferably 2 and 3.5 times greater than the thickness of the first conductive section or second conductive section. Said distance and said thickness are measured along the direction perpendicular to the main extension plane. Preferably, the first conductive section and/or the second conductive section is covered with an isolation layer. In particular, it is provided that the contact element is covered by nickel and/or tin to realize a low contact resistance on the contact element of the contact section, in particular on a connector surface of the contact element. It is also conceivably that the contact element and the second conductive section form a single component or the second conductive section and the contact element are separated components in an assembly.

According to a preferred embodiment the first conductive section and/or the second conductive section comprises several metal sheets being stacked above each other along a stacking direction extending perpendicular to the main extension plane. Preferably, the metal sheets, being stacked above each other, are isolated from each other by an isolation layer, being arranged between at least two of the several metal sheets. For example, the metal sheets have a thickness between 0.5 mm and 5 mm, preferably between 0.75 mm and 2 mm and more preferably between 1 mm and 1.5 mm, in particular measured along the stacking direction. In particular, a height of the contact element is at least 2 to 5 times, more preferably 1.5 and 4 times and most preferably 2 and 3.5 times greater than the thickness of the first conductive section, in particular measured along the stacking direction.

Preferably, it is provided that the contact element and/or the second conductive section is made from copper. Alternatively, it is also conceivable to use a material different from copper for the contact element, such as aluminum. In particular, it is provided that the contact element and the second conductive section are covered with tin and/or nickel, simultaneously, preferably as combined component.

Furthermore, the first conductive section and the second conductive section are preferably formed by flat bodies, extending in a main extension plane, and wherein the first conductive section and the second conductive section are arranged in a common plane, being parallel to the main extension plane. In particular, it is provided that the second conductive section continues the general course of the first conductive section in a direction parallel to the main extension plane. Especially, a surface of the first conductive section is flush with a surface of the second conductive section, the surfaces being arranged in the same plane. As a consequence, the second conductive section represents a common flat part of the busbar. In particular, the first conductive section and the second conductive section have mainly the same thickness.

In particular, it is provided that the busbar has a primary conductive layer and a secondary conductive layer, being stacked above each other. Each of the primary conductive layer and/or the secondary conductive layer, i. e. the first conductive section, is assigned to respective contact elements, i. e. second conductive sections, being bonded to the primary conductive layer and/or the second conductive layer respectively. For forming the busbar, it is provided to stack the first conductive layer and the second conductive layer along a stacking direction above each other, wherein the stacking direction mainly extends perpendicular to the main extension plane. The second conductive layer, being preferably copper sheet, and the first conductive layer are arranged parallel to each other and are in particular spaced from each other by another isolation layer, in particular spaced only by another isolation layer. By reaching through the first conductive layer it is advantageously possible to arrange both the contact element of the primary conductive layer, for example a primary bushing, and the contact element of the secondary conductive layer, for example a secondary bushing, at the same side, in particular at a top side of the busbar, wherein the top side faces to the electrical component in the mounted state. Thus, both poles of a capacitors arranged on the top side of the busbar can connect respectively the first conductive layer and the second conductive layer.

Further, it is provided that the primary conductive layer and the secondary conductive layer are metal sheets having for example a thickness between 0.5 mm and 5 mm, preferably between 0.75 and 2 mm and more preferably between 1 and 1.5 mm, in particular measured along the stacking direction. In particular, a height of the primary bushing and/or a secondary bushing is at least 2 to 5 times, more preferably 1.5 and 4 times and most preferably 2 and 3.5 times greater than the thickness of the first conductive layer, in particular measured along the stacking direction. In particular, realizing the nickel and/or tin cover for the first contact element and/or the second contact element further allows to realize a low contact resistance on the primary bushing, in particular on the connector surface of the first contact element. The same applies for the secondary bushing analogously.

Preferably, the second conductive section and/or the bushing passes through the first conductive section. By passing the bushing / second conductive section through the first conductive section, it is advantageously possible to increase a contact surface between the first conductive section and the second conductive section. In particular, the laser welding is realized at the side of the part passing through the first conductive section. This simplifies the access of the laser to the planned location for the laser seam. In particular, it is advantageously possible to have an easy access at the bottom side of the busbar for the laser, if the part of the contact element or the second conductive element reaches through the opening. Thus, the laser welding seam can be easily realized by directing the laser beam on the bottom side of the first conductive layer.

Preferably, it is provided that the contact element is arranged on a top surface of the primary conductive layer and at least partially contacts the top surface of the primary conductive layer, advantageously. Further, the arrangement allows an increased contact surface between the primary conductive layer, i. e. the first conductive section, and the bushing, i. e. the second conductive section, wherein said contact surface establishes an electronic contact between the bushing and the primary conductive layer. In particular, the bushing has a conical shape. As a consequence, it is possible to further reduce the weight of the busbar.

In particular it is provided that the second conductive section includes a bushing or is formed by the bushing. According this embodiment, the first conductive section is directly connected to the contact element, i. e. the bushing. In particular, it is provided that the contact element is a bushing for receiving a pin of the electrical component. Preferably, the bushing has a hole for receiving a pin of the electronical component. Thus, for mounting the electronical component the pin can inserted into the bushing, in particular in the hole

Moreover, it is provided that the second conductive section is smaller than the first conductive section. Preferably, an extension of the first conductive section in a direction parallel to the main extension plane is more than 5 times, preferably more than 10 times and most preferably more than 15 times greater than the extension of the second conductive section, measured in the same direction. Preferably a ration of the extension of the second conductive section to the extension of the first extension is between 0.05 and 0.6, preferably between 0.1 and 0.4 and most preferably between 0.15 and 0.3.

Preferably, the first conductive section and the second conductive section have the same thickness measured in a direction perpendicular to the main extension plane. Alternatively, it is conceivable that the thickness of the first conductive section is at least 5 times, preferably at least 10 times and most preferably at least 15 times greater than the thickness of the second conductive section. Such a comparably thin second conductive section might be easily bended to simplify the access to the contact section in specific applications. It is also conceivable that the thickness of the second conductive section is different from the thickness of the first conductive section.

In particular, the first conductive section is made from bare copper, i. e. copper being not covered with nickel and/or tin. Thus, nickel and/or tin can be saved in the manufacturing process, since not the whole busbar, in particular the primary conductive layer, is covered with nickel and/or tin. Instead only the secondary conductive layer forming a part of the busbar is covered with nickel and/or tin. In particular, it is provided that the primary conductive layer is connected to the secondary conductive layer directly. It is obvious for the skilled person that the bare copper sheet representing the first conductive section can be covered with another material, for example by the isolation layer, without nickel and/or tin. In particular, the covering with another material does not extend to a region, which is bonded to the second conductive section. It is also conceivable that the first conductive section is partially covered with nickel and/or tin.

Preferably, the second conductive section is completely covered with nickel and/or tin. Thus, it is possible in an advantageous manner to establish the covering of the nickel and/or tin by a diving process and/or electrochemically. By completely covering the second conductive section, the manufacturing process of covering is simplified. At the same time by using a comparably small second conductive section, it is possible to restrict or limit the part being covered with nickel and/or tin in the finished state of the busbar.

Preferably, it is provided that in addition to the laser-welding seam, established by the laser-welding, a form-fitting between the first conductive section and the second conductive section is realized, in particular in a direction parallel to the main extension plane and/or in a direction perpendicular to the main extension plane. As a consequence, the mechanical strength of the connection between the first conductive section and the second conductive section is increased in an advantageous manner.

Preferably, the form-fitting is realized by a first curvature, bordering at least partially the first conductive section in a plane parallel to the main extension plane, and a second curvature, bordering at least partially the second conductive section, wherein the first curvature and the second curvature are shaped complementary to each other. In particular, the first curvature and the second curvature interlock with each other to realize and/or to establish the form-fitting connection between the first conductive section and the second conductive section. Preferably, the laser-welding bond or seam is realized along the first and second curvature. Thereby, it is conceivable that the modification of the first or second curvature, intended to realize the form-fitting, might be established in a direction parallel to the main extension plane and/or perpendicular to the main extension plane.

Furthermore, a laser-welding seam, in particular a single laser-welding seam, is generated
- by directing a laser beam on a top surface of the first conductive section or of the busbar, and optionally by directing another laser beam on a bottom surface of a first conductive section or of the busbar or
- several laser-welding seems are generated by directing a laser beam on the top surface of the busbar or the first conductive section and by directing another laser beam on a bottom surface of the first conductive section or of the busbar. By treating the interface region between the first conductive section and the second conductive section from both sides, i. e. at the topside and the bottom side of the busbar, it is advantageously possible to increase the welding strengths and therefore the mechanical strengths of the bond between the first conductive section and the second conductive section. In particular, the method includes also an embodiment, which uses only a single laser, wherein the laser beam is split into two different laser beams, wherein one laser beam is directed to the top surface and the other laser beam is directed to the bottom surface of the interface region between the first conductive section and the second conductive section. By directing laser light onto the topside and the bottom side of the busbar or the interface section it is further advantageously possible to accelerate the bonding process, since the laser welding seam is generated simultaneously from both side, namely from the top side and the bottom side.

Preferably, the contact section includes an opening, in particular for inserting a corresponding pin or terminal. Thus, the opening allows connecting the contact section and therefore the busbar to an external component, such as a terminal of a capacitor, IGBT and/or a cable that transfers the electric current from the busbar to a device, which needs the current. Especially, capacitors are connected with the busbar by terminals, using bolts and nuts, for example. Preferably, the laser-welding bond is spaced from the contact section. As a consequence, the laser process is simplified, since the access to the interface section between the first conductive section and the second conductive section is improved.

In particular, the second conductive section is inserted into a recess of the first conductive section. As a consequence, a contact section can be incorporated inside or within the first conductive section or, in other words, in the middle of the busbar. For example, the recess represents a hole that reaches through the whole first conductive section. Alternatively, it is also thinkable that the recess has a stepped shape and the second conductive section is inserted into the step-shaped recess formed in the first conductive section.

Preferably, the secondary conductive layer is arranged adjacent to the first conductive section. As a consequence, it is possible to realize a terminal at the outside or at the outer edge of the first conductive section by connecting such a second conductive section to the outer edge or outer rim of the first conductive section.

In particular, it is provided that a nickel plating and/or a tin plating is provided to cover the second conductive section is performed, wherein the nickel plating and/or the tin plating has a thickness between 1 µm and 50 µm, preferably between 2 and 25 µm and more preferably between 5 and 15 µm. It turned out that for said thicknesses an effective corrosion and oxidation protection can be realized, without spending too much nickel and/or tin for realizing said protection.

Preferably, a laser power is adjusted for defining a length of the laser welding seam. Thus, it is advantageously possible to control the strength and dimensions of the generated laser welding seam. Alternatively or additionally, it is conceivable to adjust a treatment duration, during which the laser welding seam is generated, for adapting the dimensions and/or the form of the generated laser welding seam.

Another aspect of the present invention concerns a busbar having a contact section, in particular realized by a method according to the present invention, comprising
- a first conductive section made from copper,
- a second conductive section, preferably made from copper, wherein the second conductive section includes the contact section or is connected to the contact section and wherein the second conductive section is at least partially covered with nickel and/or tin, and
- a laser welding bond connecting the first conductive section and the second conductive section. All specifics being mentioned in the context of method according to the present invention apply analogously to the busbar, being connected to the contact section and therefore having the contact section.

Another aspect of the present invention concerns a power distribution system having a busbar according to the present invention. All specifics and benefits being mentioned above apply analogously to the subject matter of the power distribution system and vice versa. An example for such a power distribution system is a battery package or components being used in electrical vehicles, hybrid vehicles, rail vehicles and for generating or handling renewable energy.

Wherever not already described explicitly, individual embodiments or their individual aspects and features can be combined or exchanged with one another without limiting or widening the scope of the described invention, whenever such a combination or exchange is meaningful and in the sense of this invention. Advantages which are described with respect to one embodiment of the present invention are, wherever applicable, also advantageous of other embodiments of the present invention.

In the drawings:
- **Fig. 1**: schematically shows a perspective view on a busbar according to a preferred first embodiment of the present invention,
- **Fig. 2**: schematically shows a cross-sectional view of the busbar from figure 1,
- **Fig. 3**: schematically shows a primary conductive layer for a busbar according to a second preferred embodiment of the present invention,
- **Fig. 4a**: schematically shows a primary conductive layer for a busbar according to a third preferred embodiment of the present invention,
- **Fig. 4b**: schematically shows a primary conductive layer for a busbar according to a fourth preferred embodiment of the present invention,
- **Fig. 4c**: schematically shows a primary conductive layer for a busbar according to a fifth preferred embodiment of the present invention,
- **Fig. 5**: schematically shows a connection between a busbar and a contact section according to a sixth preferred embodiment of the present invention,
- **Fig. 6**: schematically shows a connection between a busbar and a contact section according to a seventh preferred embodiment of the present invention,
- **Fig. 7**: schematically shows a connection between a busbar and a contact section according to an eighth preferred embodiment of the present invention,
- **Fig. 8**: schematically shows a connection between a busbar and a contact section according to a ninth preferred embodiment of the present invention,
- **Fig. 9**: schematically shows a connection between a busbar and a contact section according to a tenth preferred embodiment of the present invention,
- **Fig. 10**: schematically shows a connection between a busbar and a contact section according to a eleventh preferred embodiment of the present invention,

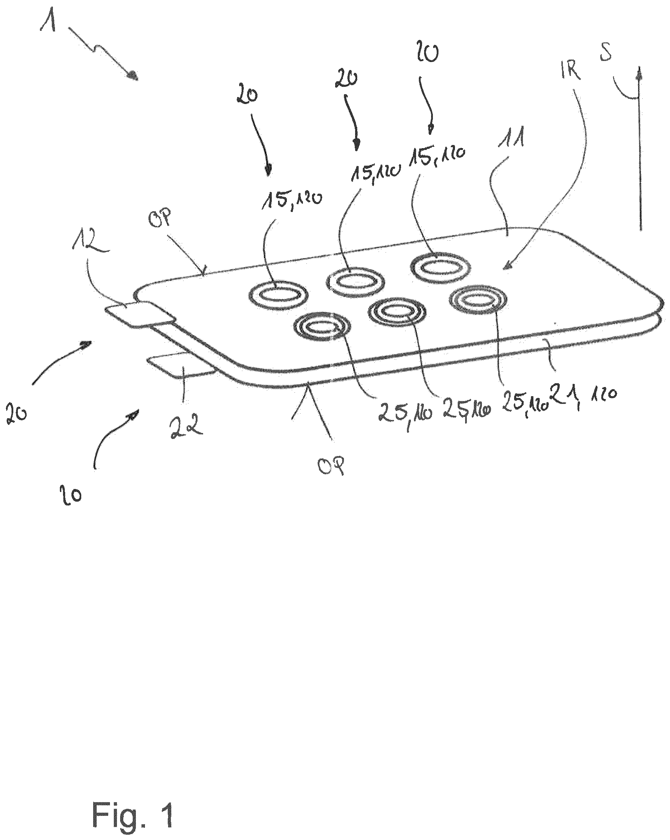

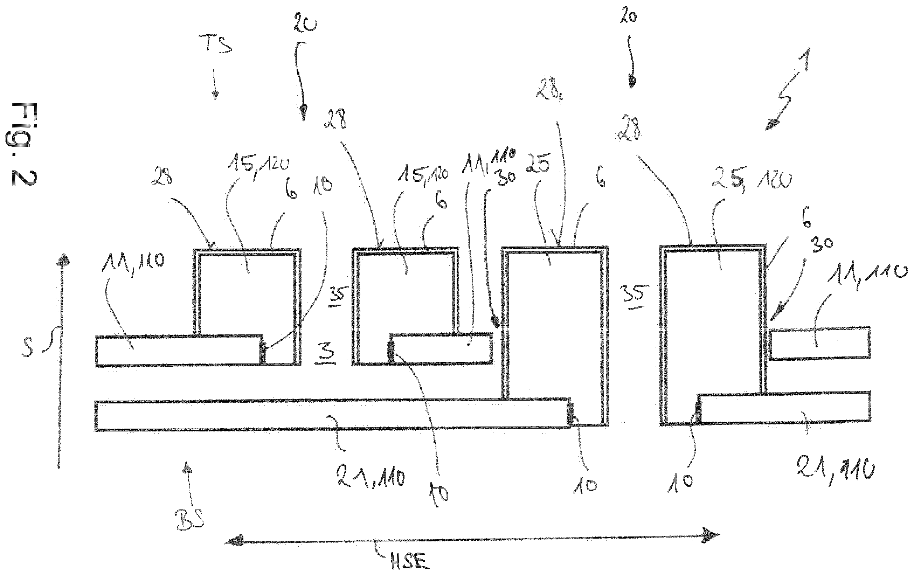

In **Figures 1** **and** **2****,** a busbar 1 according to a first preferred embodiment of the present invention is schematically illustrated, namely in a perspective view (figure 1) and a cross-sectional side view (Figure 2). Such busbars 1 according to the invention are intended for collecting and distributing electrical power/currents of an arrangement of electric components for a plurality of capacitors, which are arranged on a top side TS of the busbar 1 according to the invention. The busbar 1 extending in a main extending plane HSE forms a carrier for the electrical components that are directly arranged on the busbar 1. According to the invention, the busbar 1 comprises a primary conductive layer 11 extending in the main extending plane HSE and has a primary terminal 12, extending in a direction parallel to the main extending plane HSE from an outer periphery OP of the primary conductive layer 11, for representing a common pole of the busbar 1 that collects the contributions of several first kind of poles that are each assigned to one capacitor of the several capacitors. According to the invention, the primary conductive layer 11 is covered by an isolation layer (not shown), which allows arranging the capacitors directly on the primary conductive layer 11. Besides the primary conductive layer 11, a secondary conductive layer 21 is provided, wherein the secondary conductive layer 21 extends parallel to the primary conductive layer 11 and y the primary conductive layer 11 and the secondary conductive layer 21 are stacked on each other along a stacking direction S according to the invention. The busbar 1, in particular the primary conductive layer 11 and the secondary conductive layer 21, form a laminated or flat product, i. e. the extension of the busbar 1 in the main extending plane HSE is several times larger than the thickness of the busbar 1 measured in a direction perpendicular to the main extending plane HSE. Especially, the primary conductive layer 11 and the secondary conductive layer 21 are metal sheets having for example a thickness between 0.5 mm and 5 mm, preferably between 0.75 and 2 mm and more preferably between 1 and 1.5 mm. In particular, the material and/or the structure of the primary conductive layer 11 and the secondary conductive layer 21 are configured such that the busbar 1, at least parts of the busbar 1, can be deformed without affecting the functionality of the primary conductive layer 11 and secondary conductive layer 21. Thus, the busbar 1 can easily adapted to the space to which the busbar 1 or the assembly including the busbar 1 should be incorporated to, for example by bending a part of the busbar 1. Further, the secondary conductive layer 21 comprises at is outer periphery OP a secondary terminal 22 for representing a common pole of the busbar 1 that collects the contributions of a second kind of poles that are each assigning to one pore of several capacitors.

For connecting a first kind of poles of the capacitors, for example several positive poles, to the primary conductive layer 11 and for connecting a second kind of poles of the capacitors, for example several negative poles, to the secondary conductive layer 21, at least one primary bushing 15 is provided according to the invention for the primary conductive layer 11 and at least one secondary bushing 25 for the secondary conductive layer 21 is provided according to the invention. The primary bushing 15 and/or the second bushing 25 represent contact elements for connecting electric components to the busbar. Preferably, the primary bushing 15 protrudes from the primary conductive layer 11, in particular in a direction perpendicular to the main extension plane HSE, and/or the secondary bushing 25 protrudes form the secondary conductive layer 21, in particular in a direction perpendicular to the main extension plane HSE. Furthermore, the primary bushing 15 and/or the secondary bushing 25 are spaced from the outer periphery OP of the primary conductive layer 11 and/or the secondary conductive layer 21 and are preferably are arranged in an inner region IR of the primary conductive layer 11 and/or the secondary conductive layer 21, i. e. spaced from the outer periphery OP, in a direction parallel to the main extension plane HSE. Especially, the primary bushing 15 and the secondary bushing 25 protrude in the same direction from the busbar 1. In particular, it is provided that the primary conductive layer 11 and the secondary conductive layer 21 are arranged along a stacking direction S above each other and are spaced from each other by a further isolation layer (not shown).

Preferably, the primary bushing 15 and the secondary bushing 25 are bushings, i. e. a cylindrical body having a hole 35 for receiving a pin of the capacitor, for contacting the capacitor to the busbar 1. Thus, the primary bushing 15 and/or the secondary bushing 25 form and are configured to be a plug-in for the pins of the capacitors. It is also conceivable that the primary terminal 12 and/or the secondary terminal 22has a hole for receiving a pin of the capacitor, for contacting the capacitor to the busbar 1. Furthermore, it is provided that a height of the primary bushing 15 and/or of the secondary bushing 25 measured parallel to the stacking direction S is 5 to 15 times larger than a thickness of the busbar 1. For realizing a flat busbar 1 and an adjacent arrangement of the primary conductive layer 11 and the secondary conductive layer 21, it is provided that the primary conductive layer 11 comprises recesses 30. Thus, the secondary bushing 25 can extend through the primary conductive layer 11, in particular through the corresponding recesses 30 in the primary conductive layer 11. Especially, the height of the primary bushing 15 is smaller than a height of the secondary bushing 25. In particular, the heights of the primary bushing 15 and the secondary bushing 25 are chosen such that front sites of the primary bushing 15 and the secondary bushing 25, preferably of the bushings, facing away from the primary conductive layer 11 and the secondary conductive layer 21, finish at the same distance from the primary conductive layer 11. Consequently a flat connection surface 28 for connecting the capacitors to the bushings is realized, since these front sides are connected to the electrical components, for example the capacitors. Figure 2 shows a busbar 1 having a primary conductive layer 11 and a secondary conductive layer 21. It is obvious for the skilled person to expand the presented idea to further conductive layers and further contact elements. Not shown in Figure 1 and Figure 2 is another isolation layer that is arranged between the primary conductive layer 11 and the secondary conductive layer 21, wherein the another isolation layer guarantees the electrical isolation between the primary conductive layer 11 and the secondary conductive layer 21.

Preferably, the primary conductive layer 11 and/or the secondary conductive layer 21 forms a first conductive section 110 being made from copper. Moreover, it is conceivable, the primary bushing 15 and/or the secondary bushing 25 from a second conductive section being made from copper, too. To avoid corrosion or oxidation it is provided to cover the busbar 1 with a nickel, tin and/or selenium plating. However, covering the whole busbar 1 with the nickel, tin and/or selenium plating or cladding is expensive and complex to produce. Therefore, a busbar 1 is provided, wherein the first conductive section 110, i. e. primary conductive layer 11 and/or the secondary conductive layer 21 are made from a bare copper sheet and only the second conductive section 120, i. e. the primary bushing 11 and/or the secondary bushing 21, in particular the bushings forming the primary bushing 15 and/or the secondary bushing 25, are covered by the nickel and/or selenium plating/cladding. Preferably, the whole primary bushing 15 and/or the secondary bushing 25 is cover with the nickel, tin and/or selenium plating/cladding. Further, the nickel and/or selenium plating/cladding can protect the primary bushing 15 and/or the secondary bushing 25 to get a low contact resistance, in particular when contacting the electronic component, for example the capacitor.

Covering only the primary bushing 15 and/or the secondary bushing 25 with the selenium, tin and/or nickel plating/cladding requires a special way for realizing a durable and resistant connection between the primary conductive layer 11, in particular the bare copper sheet, and the primary bushing 15 and/or between the secondary conductive layer 21, in particular the bare copper sheet, and the secondary bushing 25. It turned out that that such a durable and resistant connection can be realized by laser welding, since laser welding technology can directly melt the material to connect the primary bushing 15 and the primary conductive layer 11.

In the embodiment shown in figure 2 it is provided that the bushings 15, 25 are configured such that a part of the bushing passes through of the primary conductive layer 11. In particular, the part passing through the primary conductive layer is opposite to the front side forming a connection surface 28 and preferably the part is configured for interacting with the primary conductive layer in a form fitting manner, in particular along a direction parallel to the main extension plane HSE. Furthermore, it is provided that part of the bushing extends through the whole opening 3 along the stacking direction S. Preferably, it is provided that the adhesive connection between the primary conductive layer 11 and the primary bushing 15 is realized by laser welding at the part passing through the primary conductive layer. Hereby, it is preferably provided that a deepness of a laser welding seam 10 is adapted in dependency of the thickness of the primary conductive layer 11 and can be realized by adjusting the laser power correspondingly. An advantage of realizing the laser welding seam 10 at the part reaching through the primary conductive layer 11 is an easy access for the laser to realize the laser welding seam 10, in particular from a bottom side BS of the primary conductive layer 11.

It further turned out that using a nickel plating shows a more stable connection between the primary conductive layer 11 and the primary bushing 15 and the laser welding seam 10 is more smooth by using laser available today, in particular compared to a primary bushing 15 covered with selenium.

Alternatively and/or additionally it is also conceivable that the primary terminal and/or the secondary terminal represents the second conductive section, being covered at least partially with nickel, tin and/or selenium and is bonded to the first conductive section, i. e. the primary conductive layer and/or the secondary conductive layer, by means of laser welding.

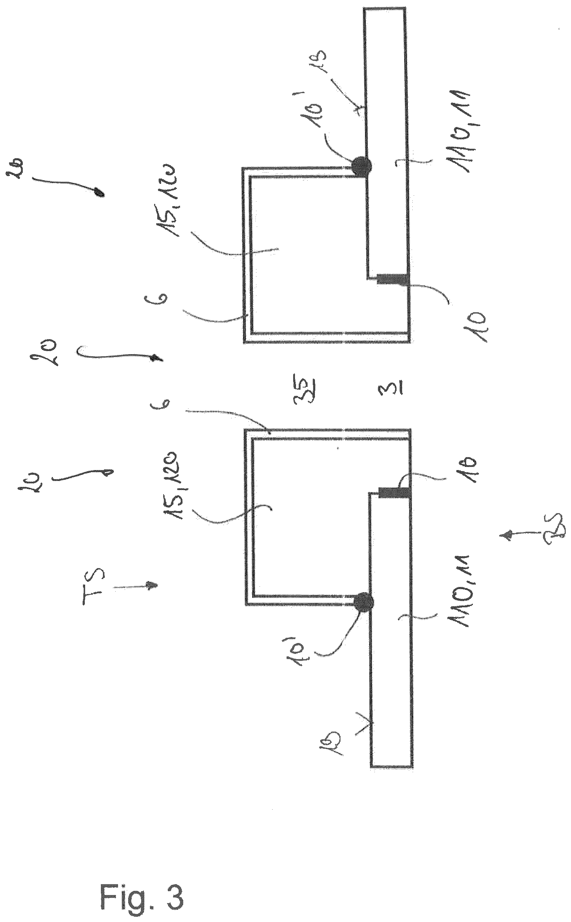

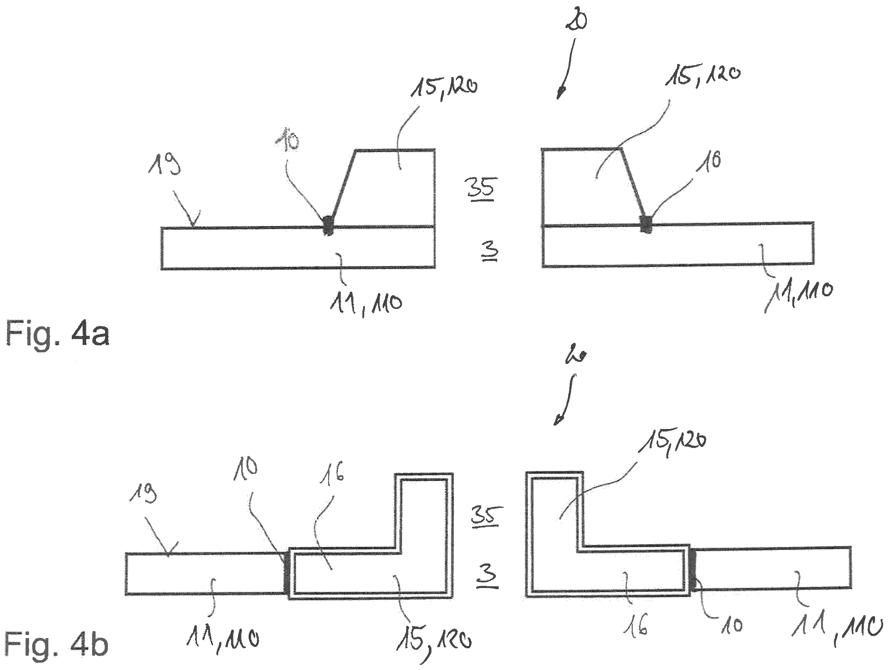

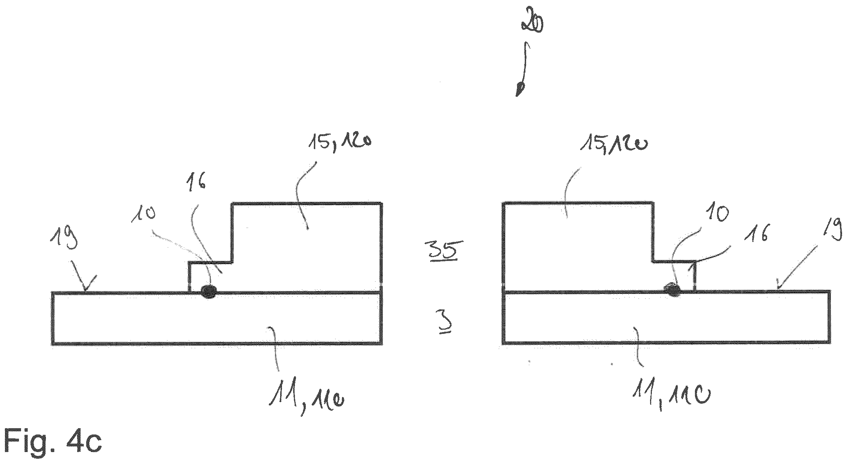

In the following figures 3, 4a, 4b and 4c, the first conductive section is formed by the primary conductive layer and the second conductive section is formed by the primary bushing.

**Figure** 3 schematically shows a primary conductive layer 11 for a busbar 1 according to a second preferred embodiment of the present invention. The primary conductive layer 11 of figure 3 mainly differs from the primary conductive layer 11 of figure 2 only by an further laser welding seam 10' between the primary bushing 15 and the primary conductive layer 11 that is realized at the top surface 19, i. e. at the top side TS, of the primary conductive layer 1 facing to the electronical component. By adding a further laser welding seam 10' it is advantageously possible to enhance a mechanical and electrical performance, in particular according to requirements of the planed application of the busbar 1.

**Figure 4a** shows a primary conductive layer 11 for a busbar 1 according to a third preferred embodiment of the present invention. In contrast to the embodiment shown in figure 2 and 3, the primary bushing 15 does not passes through the primary conductive layer 11. Thus, it is provided to adhesively connect the primary bushing 15 and the first conductive element 11 only via the further laser beam at the top surface 19 of the primary conductive layer 11. Preferably, it is provided that the bushing 15 has a conical shape.

**Figure 4b** shows a primary conductive layer 11 for a busbar 1 according to a fourth preferred embodiment of the present invention. In this embodiment the bushing has a collar 16 at the front side opposite to the electrical component and the bushing inserted in the opening 3 of the primary conductive layer 11 only contacts the inside of the primary conductive layer 11 and not the top surface 19. In particular, it is provided that the laser welding seam 10 is realized at the outer periphery of the collar 16. Thus, it is advantageously possible to realize a laser welding seam 10 by a laser beam being direct to the top surface 19 as well as being directed to the bottom surface, i. e. at the bottom side BS, of the primary conductive layer 11. Consequently, the production of the laser welding seam 10 can be accelerated.

**Figure 4c** shows a primary conductive layer 11 for a busbar 1 according to a fifth preferred embodiment of the present invention. In this embodiment the bushing is located on the primary conductive layer 11, in particular on the top surface 19, and has a collar 16 at its bottom being faced to the primary conductive layer 11. Thus, a thickness of the bushing at the collar 16 is reduced. By irradiating the collar 16 with laser light, it is possible to realize the laser welding seam 10 between the primary conductive layer 11 and the bushing, in particular between the primary conductive layer 11 and the collar 16. Preferably, the extent of the collar 16 in a direction parallel to the main extending plane is HSE adapted such that the realized laser welding seam 10 in the region of the collar 16 is strong enough for the specific application.

It is obvious to the skilled person that the connection of the primary bushing 15 and the primary conductive layer 11 can be applied to the secondary bushing 25 and the secondary conductive layer 21, analogously.

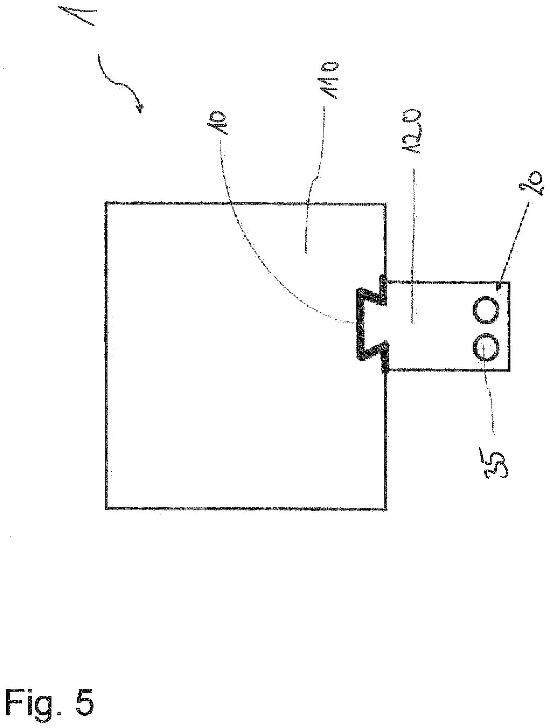

In **Fig. 5** a busbar 1, being connected to a contact section 20 according to a sixth exemplary embodiment of the present invention is illustrated. Preferably, such busbars 1 are used to collect and to transfer comparably high currents, preferably in a power distribution system. For example, such power distribution system and/or the connection of the busbar is used in an electro-motoric driven vehicle, electric locomotive or power transmission system. The contact section 20 is intended to allow a contact to an external component, in particular, to transfer a current from the busbar 1 to a cable. Preferably, the contact section 20 forms a terminal. For example, the contact section 20 includes at least one opening 21 for connection terminals (not illustrated).

Especially, it turned out that it is sufficient for the corrosion protection, if the covering of the busbar 1 with nickel and/or tin is established in the near of the contact section 20 and/or in the contact section 20, since this region is receptive for corrosion. Therefore, it is reasonable to create or to establish the covering only partially at the busbar 1, in particular in a region being closed or next to the contact section 20 and/or in the contact section 20. However, covering the busbar 1 only partially with nickel and/or tin leads to challenges in manufacturing, which has to be overcome. It turned out that it is an advantageous way to realize in a simple and effective manner the partial covering of the busbar 1 with nickel and/or tin by using a first conductive section 110 and a second conductive section 120, the second conductive section 120 including the contact section 20 and/or is connected to the contact zone 20. Thereby, the second conductive section 120 forms a part of the busbar 1 in a finished state of the connection between the contact section 20 and the busbar 1. In particular, it is provided to use a flat body, mainly extending along a main extension plane HSE as a second conductive element 120 in order to continue the general cause of the primary conductive layer 110 for forming a flat or laminated busbar 1. Furthermore, it turned out to be beneficial to use a laser-welding process to perform a bonding and/or to establish a connection between the first conductive section 110 and the second conductive section 120. In the embodiment illustrated in figure 1, the second conductive section 120 forms a lug protruding from an outer edge of the first conductive section 110. It is also conceivable that the second conductive section 120 is at least partially inserted into a recess being formed at the outer edge of the first conductive section 110 of the busbar 1. As a consequence, a contact surface, i.e. an interface section, between the first conductive section 110 and the second conductive section 120 is increased to strengthen the connection or bond between the first conductive section 110 and the second conductive section 120.

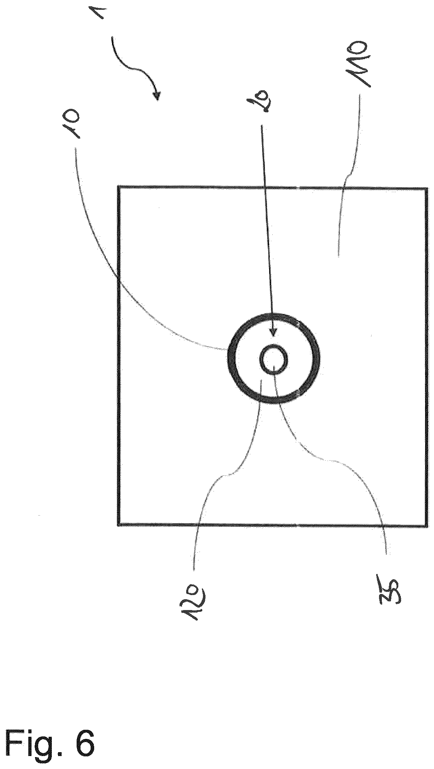

In **Fig. 6** a busbar 1 connected to a contact section 20 is illustrated according to a seventh exemplary embodiment of the present invention. In general, the embodiment illustrated in figure 6 differs from the embodiment illustrated in figure 5 by using a form-fitting interaction between the first conductive section 110 and the second conductive section 120 in addition to the bond realized by the laser welding seam 10. For establishing the form-fitting connection between the first conductive section 110 and the second conductive section 120, in particular in a direction perpendicular to the outer edge of the first conductive section 110 and parallel to the main extension plane HSE, the first conductive section 110 has a first contour and the second conductive section 120 has a second contour, the first conductive contour and the second contour having a complementary shape, in order to be connected with each other in a form-fitting manner, in particular in a direction parallel to the main extension plane HSE. Preferably, the first conductive section 110 and second conductive section 120 are connected by a dovetail-joint. As a consequence, the mechanical strength and connection between the first conductive section 110 and the second conductive section 120 is improved.

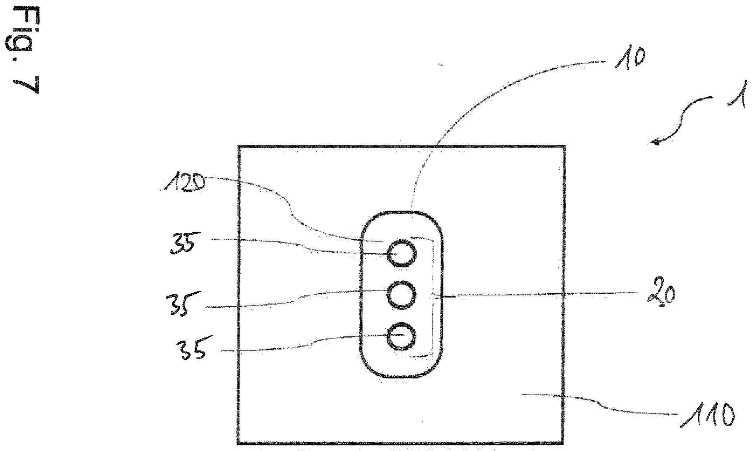

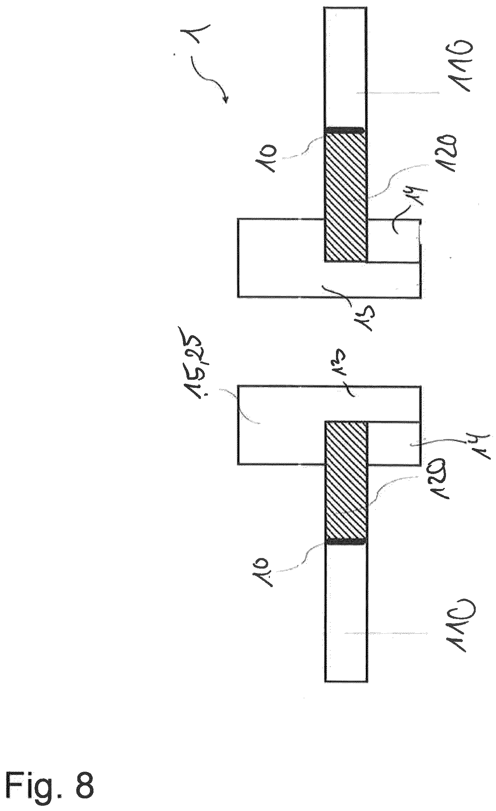

**In** **Fig. 7** a busbar 1 being connected to a contact section 20 is illustrated according to an eighth preferred embodiment of the present invention. The embodiment illustrated in figure 8 differs from the embodiment illustrated in the figures 5 and 6 mainly by the arrangement of the second conductive section 120. While in the embodiments illustrated in the figures 1 and 2, the second conductive section 120 being located adjacent to the first conductive section 110, the second conductive section 120 in the embodiment illustrated in figure 3 is located inside of the first conductive section 110. In particular, the second conductive section 120 is inserted into a corresponding recess being formed in the first conductive section 110. For example, the first conductive section 11 has a round recess or hole, which allows inserting a correspondingly shaped second conductive section 120 into the recess. In particular, it is provided for all embodiments, in particular those, which are disclosed or illustrated in the figures of the figures 5 to 7 such that the location of the welding seam 10 is spaced from the contact section 20, preferably more than 1 mm, more preferably more than 15 mm and most preferably more than 35 mm. This simplifies the manufacturing process, because the region, which has to be treated by the laser-light for forming the laser-welding bond or seam 10 has an easier access to an interface section between the first conductive section 110 and the second conductive section 120, in particular, compared to a situation, in which the contact section 20 is directly connected to the busbar 1, i. e the first conductive section 110. This is another benefit of using the second conductive section 120 as an intermediate element between the first conductive section 120, i. e. the main part of the busbar 1, and the contact section 20.

In **Fig. 8****,** a busbar 1 connected to the contact section 20 is illustrated according to a ninth preferred embodiment. The embodiment illustrated in figure 4 differs from the embodiment illustrated in figure 7 mainly by the shape and design of the contact section 20 and/or the second conductive section 12. In particular, it is provided that the contact section 20 in figure 4 has three openings 35 being located in a row. As a consequence, the contact section 20 is no longer formed circular or round and instead has an elongated shape, in particular along a direction being defined by the row of the openings 35.

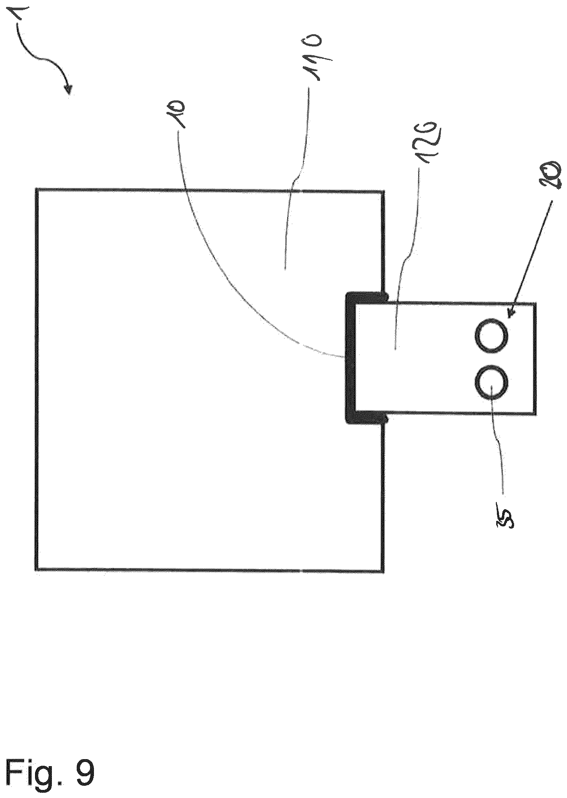

In **Fig. 9** a busbar 1 being connected to a contact section 20 is illustrated according to a tenth exemplary embodiment of the present invention. In particular, the embodiment illustrated in figure 5 refers to an embodiment having a bushing 15, which establishes the contact section 20 being connected to the busbar 1. In particular, the contact section 20 is formed as a bushing, i. e. as a cylindrical shaped body that protrudes from the busbar 1 in a direction being perpendicular to the main extension plane HSE of the busbar 1. Such a bushing 15 or cylindrical shaped contact element 15 has an opening 21 for receiving a pin, for example a pin of a capacitor, which is connected to the busbar 1. As illustrated in figure 5, the bushing or the cylindrically shaped body might have a first part 13 and a second part 14, wherein the first part 13 reaches through a hole or recess inside the second conductive section 120 and in particular reaches through this hole or recess for being connected with the second part 14 in order to fix the bushing 15 or the cylindrical shaped contact element 13, 14 to the busbar 1 in a form-fitting way, preferably in a direction being perpendicular to the main extension plane HSE. Preferably, the bushing is connected to the secondary conductive section 120 also by a laser-welding or they, i. e. the second conductive section and the contact element, form a single or monolithic body. It is also conceivable that the bushing 15 is made from aluminum or copper and/or is covered with nickel and/or tin.

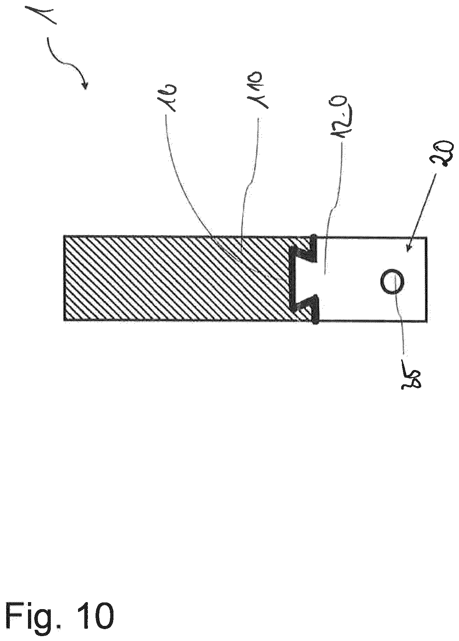

**Fig. 10** shows a connection between a busbar 1 and a contact section 20 according to a eleventh preferred embodiment of the present invention. In particular, it is provided that this embodiment refers to a busbar 1 has a stripe-like shape. In particular, it is provided that the first conductive section 110 and the second conductive section 120 have the same width measured in a direction of a general course of the interface section between the first conductive section 110 and the second conductive section 120 or mainly parallel to the direction along which the laser welding seams 10 extends. The shape of the first contour of the first conductive section 110 and the second contour of the second conductive section 120 corresponds to the one, which has been discussed in figure 2.

### Reference numbers:

- 1: busbar
- 6: cladding
- 10: seam
- 10': further seam
- 110: first conductive section
- 120: second conductive section
- 13: first part
- 14: second part
- 20: contact section
- 21: opening
- 10: laser welding seam
- 10': further laser welding seam
- 11: primary conductive layer
- 12: primary terminal
- 15: primary bushing
- 16: collar
- 19: top surface
- 21: secondary conductive layer
- 22: secondary terminal
- 25: secondary bushing
- 28: connection surface
- 30: recess
- 35: opening
- HSE: main extending plane
- S: stacking direction
- OP: outer periphery
- IR: inner region
- TS: top side
- BS: bottom side

## Claims

1. A method for forming a busbar (1) having a contact section (20) comprising:
- providing a first conductive section (110) made from copper,
- providing a second conductive section (120), in particular made from copper, wherein the second conductive section (120) includes the contact section (20) or is connected to the contact section (20) and wherein the second conductive section (120) is at least partially covered with nickel and/or tin and
- creating a laser welding bond, in particular a laser welding seam (10), between the first conductive section (110) and the second conductive section (120), by laser welding,
wherein a plurality of capacitors is arranged on a top side (TS) of the busbar (1), the busbar (1) extending in a main extending plane to form a carrier for the capacitors that are directly arranged on the busbar (1), wherein the busbar (1) comprises a primary conductive layer (11) extending in the main extending plane (HSE) and has a primary terminal (12) extending in a direction parallel to the main extending plane (HSE) from an outer periphery (OP) of the primary conductive layer (11), for representing a common pole of the busbar (1) that collects the contributions of several first kind of poles that are each assigned to one capacitor of the several capacitors, the primary conductive layer (11) being covered by an isolation layer, which allows arranging the capacitors directly on the primary conductive layer (11), wherein a secondary conductive layer (21) is provided, wherein the secondary conductive layer (21) extends parallel to the primary conductive layer (11) and the primary conductive layer (11) and the secondary conductive layer (12) are stacked on each other along a stacking direction (S), wherein at least one primary bushing (15) is provided for the primary conductive layer (11) and at least one secondary bushing (25) for the secondary conductive layer (12) is provided.

2. The method according to claim 1, wherein the first conductive section (110) and the second conductive section (120) are formed by flat bodies, extending in a main extension plane, and wherein the first conductive section (110) and the second conductive section (120) are arranged in a common plane, being parallel to the main extension plane.

3. The method according to one of the preceding claims, wherein the second conductive section (120) has a non-symmetrical, in particular a non-circular, cross section in the main extension plane (HSE).

4. The method according to one of the preceding claims, wherein the first conductive section (110) is made from bare copper.

5. The method according to one of the preceding claims, wherein the second conductive section (120) is completely covered with nickel and/or tin.

6. The method according to one of the preceding claims, wherein in addition to the laser welding bond a form-fitting is realized between the first conductive section (110) and the second conductive section (120), in particular in a direction parallel to the main extension plane (HSE) and / or in a direction perpendicular to the main extension plane (HSE).

7. The method according to one of the preceding claims, wherein
- a laser welding seam (10), in particular a single laser welding seam (10), is generated by directing a laser beam on a top surface of the first conductive section (110) and optionally by directing another laser beam on a bottom surface of the first conductive section (120) or
- several laser welding seams (10) are generated by directing a laser beam on the top surface of the first conductive section (110) and by directing another laser beam on a bottom surface of the first conductive section (110).

8. The method according to one of the preceding claims, wherein the contact section (20) includes an opening (35), in particular for inserting a corresponding terminal or pin.

9. The method according to one of the preceding claims, wherein the laser welding bond (10) is spaced from the contact section (20), preferably about a distance being greater than 1 mm, more preferably greater than 5 mm and most preferably greater than 10 mm.

10. The method according to one of the preceding claims, wherein the second conductive section (120) is inserted into a recess of the first conductive section (110).

11. The method according to one or the preceding claims, wherein the second conductive (120) layer is arranged adjacent to the first conductive section (110).

12. The method according to one of the preceding claims, wherein a nickel plating and/or a tin plating is provided to cover the second conductive section (120), wherein the nickel plating and/or the tin plating has a thickness between 1 µm and 50 µm, preferably between 2 and 25 µm and more preferably between 5 and 15 µm.

13. A busbar (1) having a contact section (20), realized by a method according to one of the preceding claims, comprising
- a first conductive section (110) made from copper,
- a second conductive section (120), wherein the second conductive section (120) includes the contact section (20) or is connected to the contact section (20) and wherein the second conductive section (120) is at least partially covered with nickel and/or tin, and
- a laser welding bond (10) connecting the first conductive section (110) and the second conductive section (120).

14. A power distribution system having a busbar (1) according to claim 13.

## Patentansprüche

1. Verfahren zum Herstellen einer Sammelschiene (1) mit einem Kontaktabschnitt (20), umfassend:
- Bereitstellen eines ersten leitenden Abschnitts (110) aus Kupfer,
- Bereitstellen eines zweiten leitenden Abschnitts (120), insbesondere aus Kupfer, wobei der zweite leitfähige Abschnitt (120) den Kontaktabschnitt (20) umfasst oder mit dem Kontaktabschnitt (20) verbunden ist und wobei der zweite leitende Abschnitt (120) zumindest abschnittsweise mit Nickel und/oder Zinn bedeckt ist, und
- Erzeugen einer Laserschweißverbindung, insbesondere einer Laserschweißnaht (10), zwischen dem ersten leitenden Abschnitt (110) und dem zweiten leitenden Abschnitt (120) durch Laserschweißen, wobei eine Vielzahl von Kondensatoren auf einer Oberseite (TS) der Sammelschiene (1) angeordnet ist, wobei sich die Sammelschiene (1) in einer Haupterstreckungsebene erstreckt, um einen Träger für die Kondensatoren zu bilden, die direkt auf der Sammelschiene (1) angeordnet sind, wobei die Sammelschiene (1) eine primäre leitfähige Schicht (11) umfasst, die sich in der Haupterstreckungsebene (HSE) erstreckt, und einen primären Anschluss (12) aufweist, der sich in einer Richtung parallel zur Haupterstreckungsebene (HSE) von einem Außenumfang (OP) der primären leitenden Schicht (11) erstreckt, um einen gemeinsamen Pol der Sammelschiene (1) auszubilden, der die Anteile mehrerer Pole erster Art vereinigt, die jeweils einem der mehreren Kondensatoren zugeordnet sind, wobei die primäre leitende Schicht (11) von einer Isolierschicht bedeckt ist, die eine Anordnung der Kondensatoren direkt auf der primären leitenden Schicht (11) ermöglicht, wobei eine sekundäre leitende Schicht (21) bereitgestellt wird, wobei die zweite leitende Schicht (21) parallel zur primären leitenden Schicht (11) erstreckt, und wobei die primäre leitende Schicht (11) und die sekundäre leitende Schicht (21) entlang einer Stapelrichtung (S) übereinandergestapelt sind, wobei zumindest eine primäre Buchse (15) für die primäre leitende Schicht (11) vorgesehen ist und zumindest eine sekundäre Buchse (25) für die zweite leitende Schicht (12) vorgesehen ist.

2. Verfahren gemäß Anspruch 1, wobei der erste leitende Abschnitt (110) und der zweite leitende Abschnitt (120) durch flache Körper gebildet sind, die sich in einer Haupterstreckungsebene erstrecken, und wobei der erste leitende Abschnitt (110) und der zweite leitende Abschnitt (120) in einer gemeinsamen Ebene angeordnet sind, die parallel zur Haupterstreckungsebene ist.

3. Verfahren gemäß einem der vorhergehenden Ansprüche, wobei der zweite leitende Abschnitt (120) einen nicht-symmetrischen, insbesondere nichtkreisförmigen, Querschnitt in der Haupterstreckungsebene (HSE) aufweist.

4. Verfahren gemäß einem der vorhergehenden Ansprüche, wobei der erste leitende Abschnitt (110) aus reinem Kupfer besteht.

5. Verfahren gemäß einem der vorhergehenden Ansprüche, wobei der zweite leitende Abschnitt (120) vollständig mit Nickel und/oder Zinn bedeckt ist.

6. Verfahren gemäß einem der vorhergehenden Ansprüche, wobei zusätzlich zu der Laserschweißverbindung eine Formschlussverbindung zwischen dem ersten leitenden Abschnitt (110) und dem zweiten leitenden Abschnitt (120) ausgebildet wird, vorzugsweise in einer Richtung parallel zu der Haupterstreckungsebene (HSE) und/oder in einer Richtung senkrecht zu der Haupterstreckungsrichtung (HSE).

7. Verfahren gemäß einem der vorhergehenden Ansprüche, wobei
- eine Laserschweißnaht (10), insbesondere eine einzelne Laserschweißnaht (10), durch Ausrichten eines Laserstrahl auf eine Oberseite des ersten leitenden Abschnitts (110) und optional durch Ausrichten eines zweiten Laserstrahls auf eine Unterseite des ersten leitenden Abschnitts (120) erzeugt wird, oder
- mehrere Laserschweißnähte (10) durch Ausrichten eines Laserstrahls auf der Oberseite des ersten leitenden Abschnitts (110) und durch Ausrichten eines zweiten Laserstrahls auf einer Unterseite des ersten leitenden Abschnitts (110) erzeugt werden.

8. Verfahren gemäß einem der vorhergehenden Ansprüche, wobei der Kontaktabschnitt (20) eine Öffnung (35), insbesondere zum Einführen eines passenden Anschlusses oder Pins, umfasst.

9. Verfahren gemäß einem der vorhergehenden Ansprüche, wobei die Laserschweißverbindung (10) von dem Kontaktabschnitt (20) beabstandet ist, bevorzugt um einen Abstand von größer als 1 mm, weiter bevorzugt von mehr als 5 mm und besonders bevorzugt von mehr als 10 mm.

10. Verfahren gemäß einem der vorhergehenden Ansprüche, wobei der zweite leitende Abschnitt (120) in einen Rücksprung des ersten leitenden Abschnitts (110) eingesetzt ist.

11. Verfahren gemäß einem der vorhergehenden Ansprüche, wobei der zweite leitende Abschnitt (120) benachbart zu dem ersten leitenden Abschnitt (110) angeordnet ist.

12. Verfahren gemäß einem der vorhergehenden Ansprüche, wobei eine Nickelbeschichtung and/oder eine Zinnbeschichtung vorgesehen ist, um den zweiten leitfähigen Abschnitt zu bedecken, wobei die Nickelbeschichtung und/oder die Zinnbeschichtung eine Dicke zwischen 1 µm und 50 µm, bevorzugt zwischen 2 und 25 µm und weiter bevorzugt zwischen 5 und 15 µm aufweist bzw. aufweisen.

13. Sammelschiene (1) mit einem Kontaktabschnitt (20), hergestellt durch ein Verfahren gemäß einem der vorherigen Ansprüche, umfassend
- einen ersten leitenden Abschnitt (110) aus Kupfer
- einen zweiten leitenden Abschnitt (120), wobei der zweite leitenden Abschnitt (120) die Kontaktfläche (20) aufweist oder mit der Kontaktfläche (20) verbunden ist und wobei der zweite leitende Abschnitt (120) zumindest abschnittsweise mit Nickel und/oder Zinn bedeck ist, und
- eine Laserschweißverbindung (10), die den ersten leitenden Abschnitt (110) und den zweiten leitenden Abschnitt (120) verbindet.

14. Stromverteilungssystem mit einer Sammelschiene (1) gemäß Anspruch 13.

## Revendications

1. Procédé de formation d'une barre omnibus (1) ayant une section de contact (20), consistant à :
- fournir une première section conductrice (110) réalisée en cuivre,
- fournir une deuxième section conductrice (120), en particulier réalisée en cuivre, la deuxième section conductrice (120) comprenant la section de contact (20) ou étant reliée à la section de contact (20), et la deuxième section conductrice (120) étant au moins partiellement recouverte de nickel et/ou d'étain, et
- créer une liaison par soudage au laser, en particulier un joint de soudure laser (10), entre la première section conductrice (110) et la deuxième section conductrice (120), par soudage au laser,
dans lequel
une pluralité de condensateurs est disposée sur une face supérieure (TS) de la barre omnibus (1), la barre omnibus (1) s'étendant dans un plan d'extension principale pour former un support pour les condensateurs qui sont disposés directement sur la barre omnibus (1),
la barre omnibus (1) comprend une couche conductrice primaire (11) s'étendant dans le plan d'extension principale (HSE) et comporte une borne primaire (12) s'étendant dans une direction parallèle au plan d'extension principale (HSE) à partir d'une périphérie extérieure (OP) de la couche conductrice primaire (11), pour constituer un pôle commun de la barre omnibus (1) qui collecte les contributions de plusieurs pôles de premier type qui sont chacun attribués à un condensateur parmi lesdits plusieurs condensateurs, la couche conductrice primaire (11) étant recouverte d'une couche isolante, ce qui permet de disposer les condensateurs directement sur la couche conductrice primaire (11),
il est prévu une couche conductrice secondaire (21), la couche conductrice secondaire (21) s'étendant parallèlement à la couche conductrice primaire (11), et la couche conductrice primaire (11) et la couche conductrice secondaire (12) étant empilées l'une sur l'autre le long d'une direction d'empilement (S),
au moins une douille primaire (15) est prévue pour la couche conductrice primaire (11) et au moins une douille secondaire (25) est prévue pour la couche conductrice secondaire (12).

2. Procédé selon la revendication 1,
dans lequel la première section conductrice (110) et la deuxième section conductrice (120) sont formées par des corps plats s'étendant dans un plan d'extension principale, et
la première section conductrice (110) et la deuxième section conductrice (120) sont disposées dans un plan commun parallèle au plan d'extension principale.

3. Procédé selon l'une des revendications précédentes,
dans lequel la deuxième section conductrice (120) présente une section transversale non symétrique, en particulier non circulaire, dans le plan d'extension principale (HSE).

4. Procédé selon l'une des revendications précédentes,
dans lequel la première section conductrice (110) est réalisée en cuivre nu.

5. Procédé selon l'une des revendications précédentes,
dans lequel la deuxième section conductrice (120) est entièrement recouverte de nickel et/ou d'étain.

6. Procédé selon l'une des revendications précédentes,
dans lequel, en plus de la liaison par soudage au laser, un ajustement de forme est réalisé entre la première section conductrice (110) et la deuxième section conductrice (120), en particulier dans une direction parallèle au plan d'extension principale (HSE) et/ou dans une direction perpendiculaire au plan d'extension principale (HSE).

7. Procédé selon l'une des revendications précédentes,
dans lequel
- un joint de soudure laser (10), en particulier un seul joint de soudure laser (10), est généré en dirigeant un faisceau laser sur une surface supérieure de la première section conductrice (110) et, en option, en dirigeant un autre faisceau laser sur une surface inférieure de la première section conductrice (120), ou
- plusieurs joints de soudure laser (10) sont générés en dirigeant un faisceau laser sur la surface supérieure de la première section conductrice (110) et en dirigeant un autre faisceau laser sur une surface inférieure de la première section conductrice (110).

8. Procédé selon l'une des revendications précédentes,
dans lequel la section de contact (20) présente une ouverture (35), en particulier pour insérer une borne ou une broche correspondante.

9. Procédé selon l'une des revendications précédentes,
dans lequel la liaison par soudage au laser (10) est espacée de la section de contact (20), de préférence d'une distance supérieure à 1 mm, de préférence supérieure à 5 mm et de manière particulièrement préférée supérieure à 10 mm.

10. Procédé selon l'une des revendications précédentes,
dans lequel la deuxième section conductrice (120) est insérée dans un évidement de la première section conductrice (110).

11. Procédé selon l'une des revendications précédentes,
dans lequel la deuxième couche conductrice (120) est disposée de manière adjacente à la première section conductrice (110).

12. Procédé selon l'une des revendications précédentes,
dans lequel un placage de nickel et/ou un placage d'étain est prévu pour recouvrir la deuxième section conductrice (120), le placage de nickel et/ou le placage d'étain ayant une épaisseur comprise entre 1 µm et 50 µm, de préférence entre 2 et 25 µm et de manière particulièrement préférée entre 5 et 15 µm.

13. Barre omnibus (1) ayant une section de contact (20), réalisée par un procédé selon l'une des revendications précédentes, comprenant
- une première section conductrice (110) réalisée en cuivre,
- une deuxième section conductrice (120), la deuxième section conductrice (120) comprenant la section de contact (20) ou étant reliée à la section de contact (20), et la deuxième section conductrice (120) étant au moins partiellement recouverte de nickel et/ou d'étain, et
- une liaison par soudage au laser (10) reliant la première section conductrice (110) et la deuxième section conductrice (120).

14. Système de distribution d'énergie comportant une barre omnibus (1) selon la revendication 13.
